# EUROPEAN PATENT APPLICATION

(11) **EP 4 819 818 A1**
(43) Date of publication of application: **07.10.2026**
(21) Application number: 26162877.0
(22) Date of filing: 06.03.2026
(51) Int. Cl.: H10K 71/00, H10K 59/131, H10D 86/40, H10D 86/60

(54) **COPPER PLASMA ETCHING METHOD, DISPLAY DEVICE MANUFACTURED THEREBY AND ELECTRONIC DEVICE INCLUDING THE SAME**

(30) Priority: 03.04.2025 KR 20250043462
(71) Applicant: Samsung Display Co., Ltd., Yongin-si, Gyeonggi-do (KR)
(72) Inventor: KIM, Sang Gab, 17113 Yongin-si, Gyeonggi-do (KR); LEE, Kyong Chol, 17113 Yongin-si, Gyeonggi-do (KR); KIM, Tae Sung, 17113 Yongin-si, Gyeonggi-do (KR)
(74) Representative: Gulde & Partner

(57) **Abstract**

A display device comprises a substrate, an insulating layer on the substrate, at least one transistor on the insulating layer, at least one signal line on the insulating layer and connected to the at least one transistor, and a light-emitting element connected to the at least one transistor, wherein the signal line includes copper, and wherein a surface of the insulating layer includes chlorine.

## Description

### BACKGROUND

### 1. Field

The present disclosure relates to a copper plasma etching method, a display device manufactured thereby, and an electronic device including the same.

### 2. Description of Related Art

As the information society develops, the demand for a display device for displaying an image is increasing in various forms. For example, display devices are applied to various electronic devices such as smartphones, digital cameras, notebook computers, navigation systems, and smart televisions.

The display device may be embodied as a flat panel display device, such as a liquid crystal display device, a field emission display device, a light-emitting display device, etc. The light-emitting display device includes an organic light-emitting display device including an organic light-emitting element, an inorganic light-emitting display device including an inorganic light-emitting element such as an inorganic semiconductor, and a micro light-emitting display device including a micro light-emitting element.

The display device may include many lines through which various signals are transmitted. The lines may be made of various metal materials, and in particular, a copper line has low resistance characteristics and thus is advantageous for use as a signal line. However, copper has a low etching processability, and thus it is difficult to apply copper to a display device.

### SUMMARY

The invention is defined by the appended claims. The description that follows is subject to this limitation. Any disclosure lying outside the scope of said claims is only intended for illustrative as well as comparative purposes.

A purpose of the present disclosure is to provide a copper plasma etching method capable of implementing a high resolution display device by improving etching processability of a copper line, a display device manufactured thereby, and an electronic device including the same.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims and combinations thereof.

According to an aspect of the present disclosure, a display device comprises a substrate, an insulating layer on the substrate, at least one transistor on the insulating layer, at least one signal line on the insulating layer and connected to the at least one transistor, and a light-emitting element connected to the at least one transistor, wherein the signal line includes copper, and wherein a surface of the insulating layer includes chlorine. The display device may be formed to a copper plasma etching method as disclosed below.

In an embodiment, the surface of the insulating layer further includes copper.

In an embodiment, a content of the chlorine is greater than a content of the copper.

In an embodiment, a ratio of a line width of each of the at least one signal line to a spacing between signal lines is in a range of 0.8/1.5 to 1.0/1.0.

In an embodiment, the at least one signal line is at least one of a scan line, a data line, an initialization voltage line, a sensing line, a first voltage line, and a second voltage line electrically connected to the at least one transistor.

According to an aspect of the present disclosure, a copper plasma etching method comprises placing a substrate into a chamber of a plasma etching apparatus, wherein the substrate has a metal layer formed thereon and including copper, supplying a first gas containing chlorine into the chamber, and performing a first etching step of plasma-etching the metal layer. The method further comprises the steps: supplying a second gas comprising hydrogen into the chamber; and performing a second etching step of plasma-etching the metal layer. Optionally, after the first etching step, the first gas is discharged.

In an embodiment, the first gas including chlorine includes at least one selected from the group consisting of Cl₂, CCl₄, BCl₃, SiCl₂, HCl, PCl₃, CHCl₂F, CHClF₂, CCl₂F₂, and ICl.

In an embodiment, the first gas does not include H₂.

In an embodiment, the first gas includes HCl. In particular, the first gas may include HCl as the only source of chlorine.

In an embodiment, the second gas including hydrogen includes H₂.

In an embodiment, a photoresist pattern as an etch mask is formed on the metal layer of the substrate.

In an embodiment, the first etching step and the second etching step constitute one cycle, and the cycle is performed a plurality of times.

In an embodiment, a temperature of a surface of the substrate is 80 degrees C or lower.

In an embodiment, in the plasma etching, following reactions occur:

Cu(s) + 1/2Cl₂(g) = CuCl(s)

CuCl(s) + 1/2Cl₂(g) = CuCl₂(s)

Cu(s) + Cl₂(g) = CuCl₂(g)

3Cu(s) + 3/2Cl₂(g) = Cu₃Cl₃(g)

3CuCl₂(s) + 3H(g) = Cu₃Cl₃(g) + 3HCl(g)

CuCl₂(s) + 3H(g) = CuH(g) + 2HCl(g)

CuCl(s) + 2H(g) = CuH(g) + HCl(g)

3CuCl₂(s) + 3/2H₂(g) = Cu₃Cl₃(g) + 3HCl(g)

where (s) refers to a solid state, and (g) refers to a gaseous state.

According to an aspect of the present disclosure, an electronic device comprises a display device for displaying an image, a memory storing therein data information necessary for operation of the display device, a processor configured to execute an application stored in the memory, and a power module configured to supply power to the display device, the memory, and the processor, wherein the display device includes a substrate, an insulating layer on the substrate, at least one transistor on the insulating layer, at least one signal line on the insulating layer and connected to the at least one transistor, and a light-emitting element connected to the at least one transistor, wherein the signal line includes copper, wherein a surface of the insulating layer includes chlorine.

In an embodiment, the display device has a resolution of 300ppi to 1700ppi.

In an embodiment, the surface of the insulating layer further includes copper.

In an embodiment, a content of the chlorine is greater than a content of the copper.

Specific details of other embodiments are included in the detailed description and drawings.

The copper plasma etching method according to an embodiment may prevent redeposition of a reaction product on a substrate or an inner wall of a chamber and improve productivity. In addition, as the copper plasma etching process is performed at a low temperature, a photoresist pattern may be used as an etching mask. In addition, a skew of the copper line may be reduced to improve reliability thereof to realize a high-resolution display device and an electronic device including the same.

The effects according to the embodiments are not limited to the effects as illustrated above, and further various effects are included in the present disclosure.

### BRIEF DESCRIPTION OF DRAWINGS

The above and other aspects and features of the present disclosure will become more apparent by describing in detail illustrative embodiments thereof with reference to the attached drawings, in which:
FIG. 1 is a block diagram of an electronic device according to an embodiment;
FIG. 2 is a schematic diagram of an electronic device according to various embodiments;
FIG. 3 is a schematic plan view of a display device according to an embodiment;
FIG. 4 is an equivalent circuit diagram of a sub-pixel according to an embodiment;
FIG. 5 is a cross-sectional view schematically illustrating a pixel of a display device according to an embodiment;
FIG. 6 is a view schematically illustrating an etching apparatus for copper plasma etching;
FIG. 7 is a flowchart of a copper plasma etching method according to an embodiment;
FIGS. 8 to 11 are diagrams illustrating structures corresponding to steps of a copper plasma etching method according to an embodiment;
FIG. 12 is a graph showing Gibbs free energy of a reaction product based on a temperature;
FIG. 13 is a flowchart of a copper plasma etching method according to another embodiment;
FIGS. 14 and 15 are diagrams illustrating structures corresponding to steps of a copper plasma etching method according to an embodiment;
FIG. 16 is a flowchart of a copper plasma etching method according to still another embodiment;
FIG. 17 is an inspection image after development of an edge portion of the copper line according to Experimental Example 1;
FIG. 18 is an inspection image after development of a center portion of the copper line according to Experimental Example 1;
FIG. 19 is an inspection image after etching the edge portion of the copper line according to Experimental Example 1;
FIG. 20 is an inspection image after etching of the center portion of the copper line according to Experimental Example 1;
FIG. 21 is an inspection image after cleaning of the edge portion of the copper line according to Experimental Example 1;
FIG. 22 is an inspection image after cleaning of the center portion of the copper line according to Experimental Example 1;
FIG. 23 is an inspection image after development of a copper line according to Experimental Example 2;
FIG. 24 is an inspection image after etching of the copper line according to Experimental Example 2;
FIG. 25 is an inspection image after cleaning of the copper line according to Experimental Example 2;
FIG. 26 is an image showing an insulating layer and a copper line manufactured according to Experimental Example 3;
FIG. 27 is a table showing an XPS analysis result of an insulating layer according to Experimental Example 3.

### DETAILED DESCRIPTION

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments will be described with reference to the accompanying drawings.

A display device according to an embodiment may be applied to various electronic devices. The electronic device according to an embodiment includes the above-described display device, and may further include a module or a device having an additional function other than the display device.

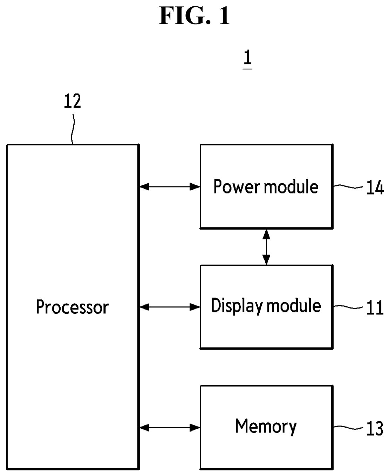

FIG. 1 is a block diagram of an electronic device according to an embodiment. Referring to FIG. 1, an electronic device 1 according to an embodiment may include a display module 11, a processor 12, a memory 13, and a power module 14.

The processor 12 may include at least one of a central processing unit (CPU), an application processor (AP), a graphics processing unit (GPU), a communication processor (CP), an image signal processor (ISP), and a controller.

Data information necessary for the operation of the processor 12 or the display module 11 may be stored in the memory 13. When the processor 12 executes an application stored in the memory 13, an image data signal and/or an input control signal may be transmitted to the display module 11, and the display module 11 may process the received signal to output image information through a display screen.

The power module 14 may include a power supply module such as a power adapter or a battery device, and a power conversion module that converts power supplied by the power supply module to generate power required for the operation of the electronic device 1.

At least one of the above-described components of the electronic device 1 may be included in the display device according to the above-described embodiments. In addition, some of the individual modules functionally included in one module may be included in the display device, and the others thereof may be provided separately from the display device. For example, the display device may include the display module 11, while each of the processor 12, the memory 13, and the power module 14 may be provided as another device in the electronic device 1 rather than the display device.

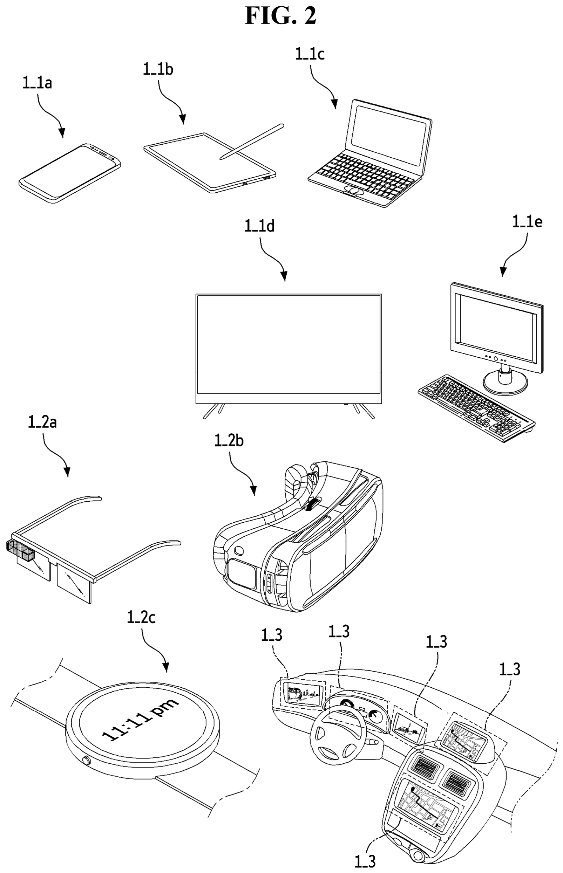

FIG. 2 is a schematic diagram of an electronic device according to various embodiments.

Referring to FIG. 2, various electronic devices to which the display device according to the embodiments is applied may include not only electronic devices for image display such as a smartphone 1_1a, a tablet PC 1_1b, a laptop 1_1c, a TV 1_1d, and a desk monitor 1_1e, but also wearable electronic devices including display modules such as a smart glasses 1_2a, a head mounted display 1_2b, and a smart watch 1_2c, electronic devices for vehicles including display modules 1_3 such as a dashboard of a vehicle, a center fascia, a center information display (CID) disposed on a dashboard, a room mirror display, etc.

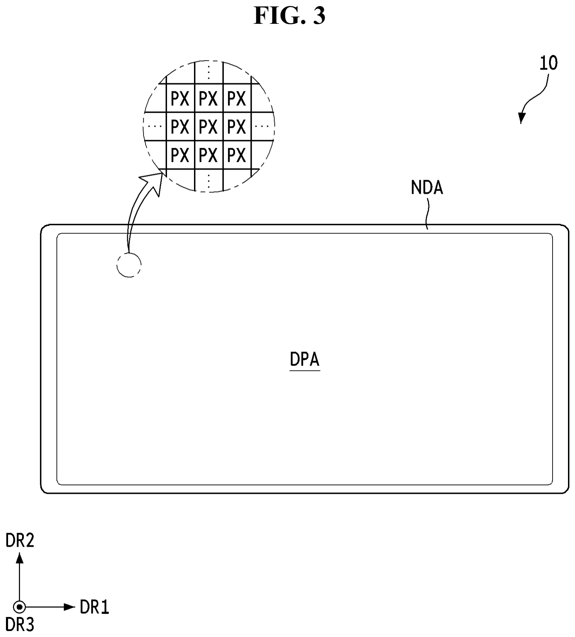

FIG. 3 is a schematic plan view of a display device according to an embodiment.

As used herein, "upper portion", "top", and "upper surface" refer to one side in a third direction DR3 of the display device 10, while "lower portion", "bottom", and "lower surface" refer to the other side in the third direction DR3. In addition, "left", "right", "upper", and "lower" indicate directions in a plan view of the display device 10. For example, "left side" indicates one side in a first direction DR1, "right side" indicates the other side in a first direction DR1, "upper side" indicates one side in a second direction DR2, and "lower side" indicates the other side in the second direction DR2.

Referring to FIG. 3, the display device 10 may display a moving image or a still image. The display device 10 may refer to all electronic devices that provide a display screen. For example, a television, a notebook computer, a monitor, a billboard, the Internet of Things, a mobile phone, a smart phone, a tablet personal computer (PC), an electronic watch, a smart watch, a watch phone, a head-mounted display, a mobile communication terminal, an electronic handbook, an electronic book, a portable multimedia player (PMP), a navigation device, a game machine, a digital camera, a camcorder, and the like that provide a display screen may be included in the display device 10.

The display device 10 may include a display panel that provides a display screen. Examples of the display panel may include an inorganic light-emitting diode display panel, an organic light-emitting display panel, a quantum dot light-emitting display panel, a plasma display panel, a field emission display panel, etc. Hereinafter, a case in which an inorganic light-emitting diode display panel is applied as an example of the display panel is described. However, embodiments of the present disclosure are not limited thereto, and as long as the same technical idea is applicable to other types of display panels, the following description may be equally applied to the other types of display panels.

A shape of the display device 10 may be variously modified. For example, the display device 10 may have a shape such as a rectangular shape having a long side extending in the first direction, a rectangular shape having a long side extending in the second direction, a square shape, a quadrilateral shape with a rounded corner (vertex), other polygons, a circular shape, etc. A shape of a display area DPA of the display device 10 in a plan view may also be similar to an overall shape of the display device 10. In FIG. 3, the display device 10 and the display area DPA having a rectangular shape having the long side extending in the first direction DR1 are illustrated.

The display device 10 may include the display area DPA and a non-display area NDA. The display area DPA is an area in which a screen may be displayed, and the non-display area NDA is an area in which a screen is not displayed. The display area DPA may be referred to as an active area, and the non-display area NDA may be referred to as a non-active area. The display area DPA may generally occupy an inner area of the display device 10.

The display area DPA may include a plurality of pixels PX. The pixels PX may be arranged in a matrix manner. A shape of each pixel PX may be a rectangular shape or a square shape in a plan view. However, embodiments of the present disclosure are not limited thereto, and the shape of each pixel PX may be a rhombus shape in which each of sides is inclined with respect to one direction. The pixels PX may be alternately arranged with each other in a stripe type or a Pentile type. In addition, each of the pixels PX may include one or more light-emitting elements ED that emit light of a specific wavelength band to display a specific color.

The non-display area NDA may be disposed around the display area DPA. The non-display area NDA may entirely or partially surround the display area DPA. The display area DPA may have a rectangular shape, and the non-display area NDA may be disposed adjacent to four sides of the display area DPA. The non-display area NDA may constitute a bezel of the display device 10. Lines or circuit drivers included in the display device 10 may be disposed in each of the non-display areas NDA, or external devices may be mounted thereon.

Each pixel PX or sub-pixel of the display device 10 includes a pixel driving circuit. The above-described lines may apply a driving signal to each pixel driving circuit while passing across or by each pixel PX. The pixel driving circuit may include a transistor and a capacitor. The number of transistors and capacitors of each pixel driving circuit may be variously modified. According to an embodiment, each pixel PX of the display device 10 may have a 3T1C structure in which the pixel driving circuit includes three transistors and one capacitor. Hereinafter, a case in which the pixel driving circuit has the 3T1C structure will be described by way of an example. However, embodiments of the present disclosure are not limited thereto, and various other modified pixel (PX) structures such as the 2T1C structure, the 7T1C structure, and the 6T1C structure may be applied.

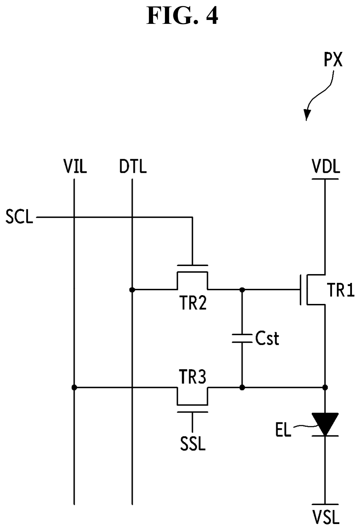

FIG. 4 is an equivalent circuit diagram of a sub-pixel according to an embodiment.

Referring to FIG. 4, each pixel PX of the display device 10 according to an embodiment may include not only a light-emitting element EL but also three transistors TR1, TR2, and TR3 and one storage capacitor Cst.

The light-emitting element EL may emit light based on a current supplied through the first transistor TR1. The light-emitting element EL may include a first electrode, a second electrode, and at least one light-emitting layer disposed therebetween. The light-emitting element may emit light of a specific wavelength band based on an electrical signal transmitted from the first electrode and the second electrode.

One end of the light-emitting element EL may be connected to the source electrode of the first transistor TR1, and the other end thereof may be connected to a second voltage line VSL to which a low potential voltage (hereinafter referred to as a second power voltage) lower than a high potential voltage (hereinafter referred to as a first power voltage) of the first voltage line VDL is supplied. In addition, the one end of the light-emitting element EL may be connected to a source electrode of the second transistor TR2.

The first transistor TR1 may adjust a current flowing from the first voltage line VDL to which the first power voltage is supplied to the light-emitting element EL based on a difference between a voltage of the gate electrode and a voltage of the source electrode. In one example, the first transistor TR1 may be a driving transistor for driving the light-emitting element EL. The gate electrode of the first transistor TR1 may be connected to the source electrode of the second transistor TR2, a source electrode thereof may be connected to the first electrode of the light-emitting element EL, and a drain electrode thereof may be connected to the first voltage line VDL to which the first power voltage is applied.

The second transistor TR2 is turned on based on a scan signal of a scan line SCL to connect a data line DTL to the gate electrode of the first transistor TR1. A gate electrode of the second transistor TR2 may be connected to the scan line SCL, a source electrode thereof may be connected to the gate electrode of the first transistor TR1, and a drain electrode thereof may be connected to the data line DTL.

The third transistor TR3 is turned on based on a sensing signal of a sensing line SSL to connect an initialization voltage line VIL to one end of the light-emitting element EL. A gate electrode of the third transistor TR3 may be connected to the sensing line SSL, a drain electrode thereof may be connected to the initialization voltage line VIL, and a source electrode thereof may be connected to one end of the light-emitting element EL or the source electrode of the first transistor TR1.

In an embodiment, the source electrode and the drain electrode of each of the transistors TR1, TR2, and TR3 are not limited to the above-described example, and the source electrode and the drain electrode of each of the transistors TR1, TR2, and TR3 may be exchanged with each other in an opposite manner to the above described manner. In addition, each of the transistors TR1, TR2, and TR3 may be embodied as a thin-film transistor. In addition, in FIG. 4, an example in which each of the transistors TR1, TR2, and TR3 is embodied as a N-type metal oxide semiconductor field effect transistor (MOSFET) is mainly described. However, embodiments of the present disclosure are not limited thereto. That is, each of the transistors TR1, TR2, and TR3 may be embodied as P-type MOSFET, or each of some of the transistors may be embodied as N-type MOSFET, while each of the others of the transistors may be embodied as P-type MOSFET.

The storage capacitor Cst is formed between the gate electrode and the source electrode of the first transistor TR1. The storage capacitor Cst stores therein a difference voltage between the gate voltage and the source voltage of the first transistor TR1.

Hereinafter, a structure of one pixel PX of the display device 10 according to an embodiment will be described in detail with reference to further drawings.

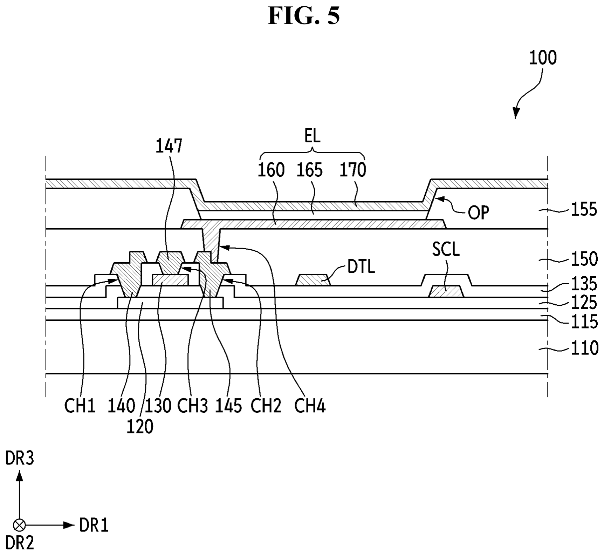

FIG. 5 is a cross-sectional view schematically illustrating a pixel of a display device according to an embodiment. In FIG. 5, a structure of a display substrate 100 described above will be described in detail.

Referring to FIG. 5, the display substrate 100 of the display device 10 according to an embodiment may include a substrate 110. The substrate 110 may be a base substrate or a base member, and may be made of a transparent insulating material. For example, the substrate 110 may include glass or a polymer material. When the substrate 110 includes glass, the substrate 110 may be a rigid substrate. When the substrate 110 includes a polymer material, the substrate 110 may be a flexible substrate capable of bending, folding, rolling, etc. In the present embodiment, an example in which the substrate 110 is a rigid substrate including glass will be described. However, embodiments of the present disclosure are not limited thereto, and the substrate 110 may be a flexible substrate including polyimide (PI).

A buffer layer 115 may be disposed on the substrate 110. The buffer layer 115 may be formed as an inorganic film capable of preventing the penetration of air or moisture. The buffer layer 115 may include a silicon compound, a metal oxide, etc. For example, the buffer layer 115 may include silicon oxide, silicon nitride, silicon oxynitride, aluminum oxide, tantalum oxide, hafnium oxide, zirconium oxide, titanium oxide, etc. These may be used alone or in combination with each other. The buffer layer 115 may be a single film or a multilayer film composed of a stack of various films made of different materials.

A transistor TFT may be disposed on the buffer layer 115. The transistor TFT may include a semiconductor layer 120, a gate electrode 130, a source electrode 140, and a drain electrode 145. The transistor TFT may constitute a pixel circuit of each of the plurality of pixels PX. For example, the transistor TFT may be a driving transistor or a switching transistor of the pixel circuit. In the drawing, it is illustrated that one transistor TFT is disposed in the pixel PX of the display device 10. However, embodiments of the present disclosure are not limited thereto, and the display device 10 may include a larger number of transistors.

The semiconductor layer 120 may be disposed on the buffer layer 115. The semiconductor layer 120 may be disposed to partially overlap the gate electrode 130 of a first conductive layer to be described later.

The semiconductor layer 120 may include polycrystalline silicon, single crystal silicon, an oxide semiconductor, etc. In another embodiment, the semiconductor layer 120 may include polycrystalline silicon. The oxide semiconductor may be an oxide semiconductor containing indium (In). For example, the oxide semiconductor may be at least one of Indium Tin Oxide (ITO), Indium Zinc Oxide (IZO), Indium Gallium Oxide (IGO), Indium Zinc Tin Oxide (IZTO), Indium Gallium Tin Oxide (IGTO), Indium Gallium Zinc Oxide (IGZO), and Indium Gallium Zinc Tin Oxide (IGZTO).

A gate insulating layer 125 may be disposed on the semiconductor layer 120. The gate insulating layer 125 may be disposed on the substrate 110 including the semiconductor layer 120. The gate insulating layer 125 may serve as a gate insulating film of the transistor TFT. The gate insulating layer 125 may include a silicon compound, a metal oxide, etc. For example, the gate insulating layer 125 may include silicon oxide, silicon nitride, silicon oxynitride, aluminum oxide, tantalum oxide, hafnium oxide, zirconium oxide, titanium oxide, etc. These may be used alone or in combination with each other. The gate insulating layer 125 may be embodied as a single film or a multilayer film formed as a stack of various films made of different materials.

The gate electrode 130 may be disposed on the gate insulating layer 125. The gate electrode 130 may be disposed to overlap a channel area of the semiconductor layer 120 in the third direction DR3 as a thickness direction. The scan line SCL may be disposed on the gate insulating layer 125 so as to be spaced apart from the gate electrode 130. The scan line SCL may be electrically connected to the gate electrode 130.

An interlayer insulating layer 135 may be disposed on the gate electrode 130 and the scan line SCL. The interlayer insulating layer 135 may be disposed on the gate electrode 130, the scan line SCL, and the gate insulating layer 125. The interlayer insulating layer 135 may function as an insulating film between the gate electrode 130, the scan line SCL, and other layers disposed thereon. In addition, the interlayer insulating layer 135 may be disposed to cover the gate electrode 130 and the scan line SCL to protect them.

The interlayer insulating layer 135 may include a silicon compound, a metal oxide, etc. For example, the interlayer insulating layer 135 may include silicon oxide, silicon nitride, silicon oxynitride, aluminum oxide, tantalum oxide, hafnium oxide, zirconium oxide, titanium oxide, etc. These may be used alone or in combination with each other. The interlayer insulating layer 135 may be embodied as a single film or a multilayer film formed as a stack of various films made of different materials.

The source electrode 140 and the drain electrode 145 may be disposed on the interlayer insulating layer 135. The source electrode 140 may be connected to the semiconductor layer 120 via a first contact hole CH1 extending through the interlayer insulating layer 135 and the gate insulating layer 125. The drain electrode 145 may be connected to the semiconductor layer 120 via a second contact hole CH2 extending through the interlayer insulating layer 135 and the gate insulating layer 125.

A connection electrode 147 may be disposed between the source electrode 140 and the drain electrode 145. The connection electrode 147 may serve to connect the gate electrode 130 to a circuit connected to the transistor TFT. The connection electrode 147 may be connected to the gate electrode 130 via a third contact hole CH3 that extends through the interlayer insulating layer 135. For example, the connection electrode 147 may be electrically connected to the scan line SCL. The data line DTL may be disposed on the interlayer insulating layer 135 so as to be spaced apart from the source electrode 140 and the drain electrode 145. The data line DTL may be electrically connected to the source electrode 140 or the drain electrode 145.

Each of the source electrode 140, the drain electrode 145, the data line DTL, and the connection electrode 147 may include one or more metals selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). Each of the source electrode 140, the drain electrode 145, the data line DTL, and the connection electrode 147 may be embodied as a single film or a multilayer film formed as a stack of various films made of different materials.

A surface of the gate insulating layer 125 or the interlayer insulating layer 135 described above may include copper and chlorine. In this regard, the surface refers to a surface thereof around at least one signal line of the gate electrode 130, the scan line SCL, the source electrode 140, the drain electrode 145, or the data line DTL. As will be described later, at least one signal line of the gate electrode 130, the scan line SCL, the source electrode 140, the drain electrode 145, and the data line DTL may include copper and may be formed in a copper plasma etching process. In this case, copper and chlorine may remain on the surface of at least one of the insulating layers, for example, the gate insulating layer 125 or the interlayer insulating layer 135 on which the signal lines are formed in the copper plasma etching process. That is, when the copper plasma etching process to be described later is used, copper and chlorine may be detected on the surface of at least one of the gate insulating layer 125 or the interlayer insulating layer 135. In an embodiment, at least one of the gate insulating layer 125 or the interlayer insulating layer 135 may have a chlorine content greater than a copper content on the surface thereof.

In an embodiment, a ratio L/S of a line width of the signal lines to a spacing between the signal lines of at least one of the gate electrode 130, the scan line SCL, the source electrode 140, the drain electrode 145, or the data line DTL may be in a range of 0.8/1.5 to 1.0/1.0. For example, the ratio L/S of the line width of the signal line to the spacing between the signal lines may be realized as1.0/1.5, 1.0/1.0, or 0.8/1.0. For example, the line width of the signal line may be in a range of 0.8 to1.0, and the spacing between the signal line may be in a range of 1.0 to 1.5. In addition, when the ratio of the line width of the signal line to the spacing between the signal lines is1.0/1.5, a resolution of about 1700ppi (pixel per inch) may be realized, and when the ratio of the line width of the signal line to the spacing between the signal lines is 1.0/1.0 or 0.8/1.0, a resolution of about 1500ppi may be realized. For example, a high resolution of about 1500ppi to about 1700ppi may be realized using the copper plasma etching method to be described later. Accordingly, the display device 10 according to an embodiment may realize a resolution of about 300ppi to 1700ppi.

In an embodiment, the above-described signal lines may include not only the gate electrode 130, the scan line SCL, the source electrode 140, the drain electrode 145, and the data line DTL, but also the initialization voltage line VIL, the sensing line SSL, the first voltage line VDL, and the second voltage line VSL as illustrated in FIG. 4, and may include all other signal lines that may be made of copper.

In one example, a via layer 150 may be disposed on the source electrode 140, the drain electrode 145, the data line DTL, and the connection electrode 147. The via layer 150 may planarize an underlying step to improve a film-forming property of the first electrode 160 formed thereon.

The via layer 150 may include an inorganic insulating material or an organic insulating material such as polyacrylate resin, epoxy resin, phenolic resin, polyamide resin, polyimide resin, unsaturated polyester resin, polyphenylenether resin, polyphenylenesulfide resin, or benzocyclobutene (BCB). The via layer 150 may be embodied as a single film or a multilayer film formed as a stack of various films made of different materials.

The light-emitting element EL may be disposed on the via layer 150. The light-emitting element EL may include a first electrode 160, a light-emitting layer 165, and a second electrode 170.

The first electrode 160 may be disposed on the via layer 150. The first electrode 160 may be disposed in each sub-pixel SPX and may be formed in a pattern shape. The first electrode 160 may be an anode electrode of the light-emitting element EL. The first electrode 160 may be connected to the drain electrode 145 of the transistor TFT via a fourth contact hole CH4 extending through the via layer 150.

The first electrode 160 may include a transparent conductive material. For example, the first electrode 160 may include a material such as indium tin oxide (ITO), indium zinc oxide (IZO), indium tin-zinc oxide (ITZO), etc. In some embodiments, the first electrode 160 may have a structure in which at least one transparent conductive material layer and at least one metal layer having high reflectance are stacked on top of each other, or may be formed as one layer including the transparent conductive material and the metal having high reflectance. For example, the first electrode 160 may have a stacked structure of ITO layer/silver (Ag) layer/ITO layer/ITO layer/Ag layer/IZO layer, or ITO layer/Ag layer/ITZO layer/IZO layer.

A bank layer 155 may be disposed on the first electrode 160. The bank layer 155 may include an opening OP defined therein partially exposing the first electrode 160. The bank layer 155 may be made of an organic insulating material or an inorganic insulating material. For example, the bank layer 155 may include at least one of a photoresist, a polyimide-based resin, an acryl-based resin, a silicon compound, a polyacrylic resin, etc.

The light-emitting layer 165 may be disposed on the first electrode 160. The light-emitting layer 165 may further include at least one of a hole injection layer, a hole transport layer, an electron transport layer, and an electron injection layer. The light-emitting layer 165 may emit red, blue, and green light or white light in each sub-pixel SPX. When the light-emitting layer 165 emits white light, red, blue, and green light may be realized through a wavelength conversion member.

The second electrode 170 may be disposed on the light-emitting layer 165 and the bank layer 155. The second electrode 170 may be disposed entirely across the display area of the substrate 110. The second electrode 170 may be a common electrode disposed over the plurality of sub-pixels SP. The second electrode 170 may be a cathode electrode of the light-emitting element EL.

In one example, the gate electrode 130, the scan line SCL, the source electrode 140, the drain electrode 145, the connection electrode 147, and the data line DTL described above may be metal layers (or conductive layers) and may belong to the signal lines. These signal lines are entirely disposed on the display device 10 and serve to transmit various signals. The signal lines may have a low resistance so that the signal may be substantially equally transmitted to all pixels. Copper (Cu) may be a representative metal material having low resistance.

Hereinafter, a method for plasma etching the signal lines including copper will be described.

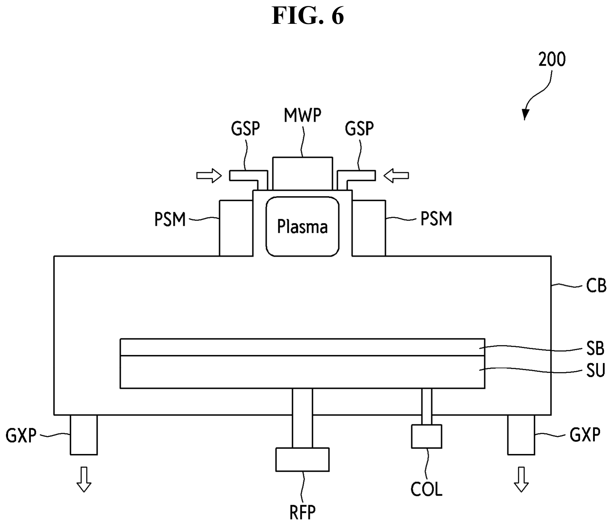

FIG. 6 is a view schematically illustrating an etching apparatus for copper plasma etching.

Referring to FIG. 6, the copper plasma etching method according to an embodiment may be performed using an etching apparatus 200. The etching apparatus 200 may include a chamber CB, a susceptor SU, a microwave generator MWP, a magnetic field generator PSM, and a high frequency power supply RFP. In addition, the etching apparatus 200 may include a gas supply GSP, a gas exhaust part GXP, a cooling unit COL, etc.

The etching apparatus 200 may be an electron cyclotron resonance (ECR) plasma etching apparatus capable of obtaining a high-density plasma having a high plasma electron temperature simultaneously using an electric field and a magnetic field. The magnetic field may be generated in the chamber CB using the magnetic field generator PSM, and microwaves generated using the microwave generator MWP may be input into the chamber CB. When a spin frequency of electrons due to the magnetic field and the microwave frequency coincide with each other, the electron cyclotron resonance phenomenon occurs. When the gas is supplied to an ECR area, the gas is ionized to generate the plasma. While the electrons in the plasma migrate through the ECR area, the electrons are accelerated under the resonance to obtain large energy. Since a diffusion loss of the electrons is reduced under the magnetic field such that the gas is easily ionized, high-density plasma having a high plasma electron temperature may be generated.

The chamber CB may provide a treatment space in which an etching process is performed. The chamber CB may maintain a vacuum state during the etching process. For example, the chamber CB may provide a pressure of 10⁻⁴ to 10⁻² Torr while the etching process is performed. The etching gas in the plasma state may be generated in the treatment space of the chamber CB. The chamber CB may include a ceramic material having resistance to plasma.

A target substrate SB may correspond to a substrate on which the lines and/or electrodes of the display device 10 described above are formed. The target substrate SB may include an insulating layer and at least one metal layer. For example, in order to form the data line DTL illustrated in FIG. 5, the target substrate SB provided to the etching apparatus 200 may correspond to the plurality of insulating layers 115, 125, and 135 of the transistor stacked on the substrate 110 of FIG. 5. In addition, the metal layer of the target substrate SB to be etched may correspond to a copper layer deposited on the insulating layer to be patterned into the data line DTL. However, embodiments of the present disclosure are not limited thereto, and electrodes such as the gate electrode 130 of FIG. 5 of the display device 10 or lines such as the scan line SCL may be formed thereon.

The susceptor SU may be disposed in a treatment space defined in the chamber CB. The susceptor SU may support the target substrate SB thereon so as to be positioned under the microwave generating unit MWP. The susceptor SU may support and transfer the target substrate SB. The susceptor SU may support the target substrate SB such that the metal layer of the target substrate SB to be etched faces the microwave generator MWP.

The magnetic field generator PSM may generate the magnetic field in the treatment space of the chamber CB on top of the target substrate SB. The magnetic field generator PSM may be disposed to surround a partial area of a top side of the chamber CB to generate a magnetic field in the treatment space in the chamber CB.

The microwave generator MWP may be disposed on top of the chamber CB. For example, the microwave generator MWP may be disposed to face the target substrate SB, and the magnetic field generator PSM may be disposed between the microwave generator MWP and the target substrate SB. The microwave generator MWP may provide microwaves to an area in which the magnetic field is generated.

The high frequency power supply RFP may be disposed outside the chamber CB. The high frequency power supply RFP may be connected to the susceptor SU to apply the high frequency RF to the susceptor SU. The output frequency of the high frequency power supply RFP may be in a range of several hundred kHz to tens of MHz. When plasma etching is performed together with the high frequency of the high frequency power supply RFP, an ion reaction of the reactive ion etching (RIE) may be added. This may be advantageous for anisotropic etching.

The gas supply GSP may be disposed on top of the chamber CB. The gas supply GSP may be disposed between the microwave generator MWP and the magnetic field generator PSM to supply an etching gas. In an embodiment, the gas supply GSP may supply a first etching gas and a second etching gas.

The gas exhaust part GXP may be disposed under the chamber CB. However, embodiments of the present disclosure are not limited thereto, and the gas exhaust part GXP may be disposed on top of the chamber CB. The gas exhaust part GXP may include a vacuum pump. The gas exhaust part GXP may operate a vacuum pump to maintain the inside of the chamber CB in a vacuum state and discharge the etching gas when the etching reaction is stopped.

The cooling unit COL may be disposed under the chamber CB. The cooling unit COL may be connected to the susceptor SU to cool the susceptor SU. The cooling unit COL may cool the susceptor SU to a temperature of about - tens of degrees C to maintain the surface temperature of the target substrate SB at a temperature under 80 degrees C.

Hereinafter, steps of a copper plasma etching method according to an embodiment will be described with reference to the drawings.

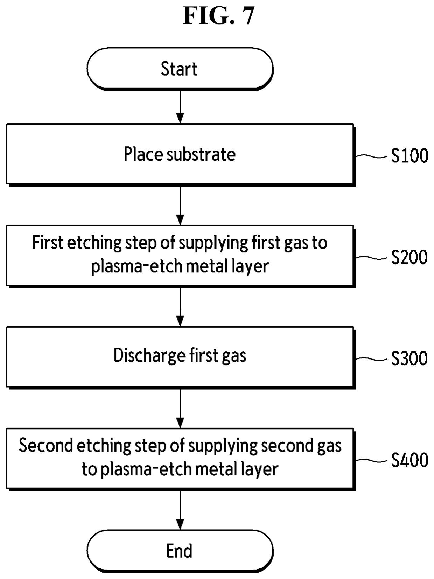

FIG. 7 is a flowchart of a copper plasma etching method according to an embodiment. The copper plasma etching method according to an embodiment may be performed in the chamber for plasma etching as described above.

Referring to FIG. 7, the copper plasma etching method according to an embodiment may include a placing step S100 of placing the target substrate, a first etching step S200 of plasma-etching the metal layer by supplying the first gas, a first gas discharging step S300, and a second etching step S400 of plasma-etching the metal layer by supplying the second gas.

In the step S100 of placing the target substrate, the target substrate may be placed into the chamber. The target substrate SB may include a metal layer to be etched. The metal layer may include copper. The metal layer may be formed by depositing a metal material on the target substrate SB to form the signal lines SL of the display device as described above. The target substrate SB may be placed on the susceptor SU of the chamber CB and may be disposed inside the chamber CB.

In the first etching step S200, the metal layer formed on the target substrate may be first etched. The first gas supplied in the first etching step S200 may include chlorine. The first gas is used for plasma-etching the metal layer, and may include, for example, at least one selected from the group consisting of Cl₂, CCl₄, BCl₃, SiCl₂, HCl, PCl₃, CHCl₂F, CHClF₂, CCl₂F₂, and ICl.

In the first etching step S200, the metal layer of the target substrate may be etched by the plasma. The first gas may be converted to plasma by the microwave generator and the magnetic field generator as described above. For example, the chlorine of the first gas may be converted to plasma by the microwave generator and the magnetic field generator and then the generated plasma may react with copper of the metal layer in the form of ions or radicals. The first etching step S200 may be a step of producing a reactant by reacting the copper with chlorine of the first gas.

In the first gas discharge step S300, the first gas existing in the chamber may be discharged to the outside out of the chamber. In an embodiment, in the first gas discharge step S300, the first gas may be entirely removed from the chamber. In another embodiment, in the first gas discharge step S300, a portion of the first gas may be discharged from the chamber, and the remaining portion may remain in the chamber. The first gas may be discharged through a pump provided at an outlet of the chamber.

In the second etching step S400, the metal layer formed on the target substrate may be second etched. The second gas supplied in the second etching step S400 may include hydrogen. The second gas is used for plasma etching the metal layer, and may include, for example, H₂.

In the second etching step S400, the metal layer of the target substrate may be etched by plasma. The second gas may be converted to plasma by the microwave generator and the magnetic field generator as described above. For example, the hydrogen of the second gas may be converted to plasma by the microwave generator and the magnetic field generator and the generated plasma may react with the reactant (e.g., the reactant produced via the reaction of copper and chlorine) produced in the first etching step S200 in the form of ions or radicals. When the reactant and the hydrogen react each other, a reaction gas may be generated, and the reactant may be removed, and thus the metal layer may be etched.

Hereinafter, steps of a copper plasma etching method according to an embodiment will be described with reference to the drawings.

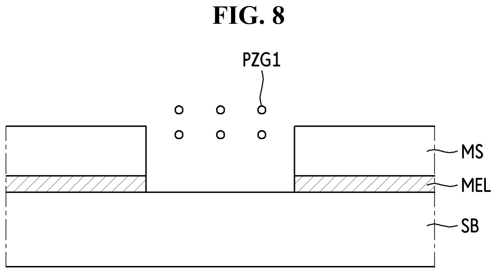

FIGS. 8 to 11 are diagrams illustrating structures corresponding to steps of a copper plasma etching method according to an embodiment.

Referring to FIG. 8 in conjunction with FIGS. 6 and 7, the step S100 of placing the target substrate is performed. The target substrate SB may be placed on the susceptor SU in the chamber CB. The target substrate SB may have a metal layer MEL deposited thereon, wherein the metal layer includes the copper. In addition, the target substrate SB may be placed such that the metal layer MEL faces upwardly. An etching mask MS may be formed on the metal layer MEL of the target substrate SB. The etching mask MS may be a photoresist pattern or a hard mask pattern.

Subsequently, after the target substrate SB has been placed on the susceptor SU, the first etching step S200 of plasma-etching the metal layer MEL by supplying the first gas is performed.

In an embodiment, a vacuum state is generated in the chamber CB of the etching apparatus 200. The inside of the chamber CB may be maintained in the vacuum state through a vacuum pump of the gas exhaust part GXP, and may be maintained at a pressure of 10⁻⁴ to 10⁻² Torr.

Subsequently, the microwave generator MWP provides microwaves to the chamber CB, and the magnetic field generator PSM generates the magnetic field in the chamber CB. At the same time, a high frequency is applied from the high frequency power supply RFP to the susceptor SU.

Thereafter, the first gas is supplied into the chamber CB. The first gas is used for plasma-etching the metal layer MEL, and may be supplied into the chamber CB through the gas supply GSP. The first gas may include chlorine. For example, the first gas may include any one or more selected from the group consisting of Cl₂, CCl₄, BCl₃, SiCl₂, HCl, PCl₃, CHCl₂F, CHClF₂, CCl₂F₂, and ICl.

As the first gas is supplied into the chamber CB, the plasma of the first gas, for example, the first plasma gas, is generated by the microwaves of the microwave generator MWP and the magnetic field of the magnetic field generator PSM. As the first gas includes the chlorine, the first plasma gas PZG1 may contain chlorine ions and chlorine radicals. The metal layer MEL of the target substrate SB which is not covered with the etching mask MS is etched with the chlorine ions and the chlorine radicals.

In the first etching step S200, following reactions may occur step by step or independently:

Cu(s) + 1/2Cl₂(g) = CuCl(s)

CuCl(s) + 1/2Cl₂(g) = CuCl₂(s)

Cu(s) + Cl₂(g) = CuCl₂(g)

3Cu(s) + 3/2Cl₂(g) = Cu₃Cl₃(g)

where (s) refers to a solid state, and (g) refers to a gaseous state.

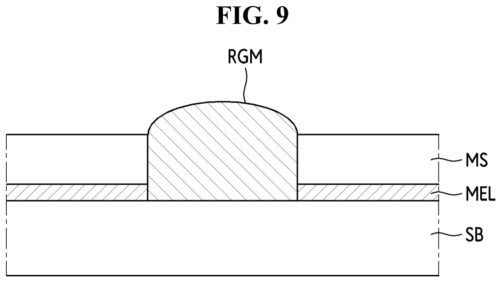

As shown in FIG. 9, the chlorine ions and the chlorine radicals of the first plasma gas PZG1 generated in the first etching step S200 may react with the metal layer to produce a reaction product RGM. For example, the chlorine ions and the chlorine radicals may react with copper of the metal layer to produce solid state CuCl and CuCl₂ as the reaction product RGM, and to produce gaseous state CuCl₂ and Cu₃Cl₃ as the reaction product RGM. In this regard, the gaseous CuCl₂ and Cu₃Cl₃ are vaporized and exhausted to the outside out of the chamber CB, while the solid state CuCl and CuCl₂ are stacked on the surface of the target substrate or the inner wall of the chamber CB. In particular, since CuCl and CuCl₂ have boiling points of about 324 degrees C and about 280 degrees C at 1mTorr, respectively, it is not easy to remove them at low temperatures. On the other hand, Cu₃Cl₃ has a boiling point of about 139 degrees C at 1mTorr. Thus, it is easy to remove the Cu₃Cl₃ even at low temperatures.

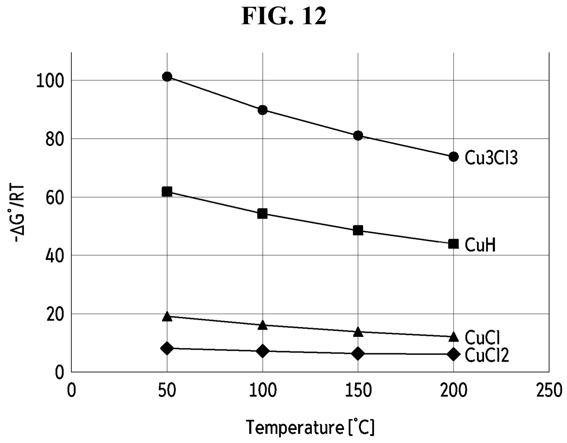

FIG. 12 is a graph showing Gibbs free energy of the reaction product based on a temperature.

Referring to FIG. 12, CuCl and CuCl₂ exhibit Gibbs free energy lower than about 20 -△G°/RT at a temperature in the range of 50 degrees C to 150 degrees C, whereas CuH and Cu₃Cl₃ exhibit Gibbs free energy greater than or equal to about 60 -△G°/RT at a temperature in the range of 50 degrees C to 150 degrees C. That is, it may be identified that CuH and Cu₃Cl₃ are easily vaporized at a lower temperature than CuCl and CuCl₂ are.

In the second etching step S200 to be described later, the solid state CuCl and CuCl₂ generated in the first etching step S200 may be converted to Cu₃Cl₃ in a gaseous state at a low temperature and CuH that may be vaporized at room temperature, thereby facilitating the copper plasma etching.

Referring back to FIG. 7, after the first etching step S200, the first gas discharging step S300 of discharging the first gas is performed.

In the first gas discharge step S300, the supply of the first gas may be stopped. In an embodiment, the pressure of the chamber CB is maintained in the vacuum state under the operation of the vacuum pump of the gas exhaust part GXP. When the supply of the first gas is stopped, the first gas, the first plasma gas, and the reaction product present in the chamber CB may be discharged through the vacuum pump of the gas exhaust part GXP.

At least a portion of the first gas may be discharged in the first gas discharge step S300. For example, an entirety of the first gas present in the chamber CB may be removed. In another example, at least a portion of the first gas may remain in the chamber CB. The first gas discharge step S300 may be performed for several seconds to several tens of seconds.

Subsequently, the second etching step S400 of plasma-etching the metal layer MEL by supplying the second gas is performed.

In an embodiment, the second gas is supplied into the chamber CB. The second gas is used to remove the reaction product RGM generated in the first etching step S 200, and may be supplied into the chamber CB through the gas supply GSP. The second gas may include hydrogen. For example, the second gas may include H₂.

As the second gas is supplied into the chamber CB, a plasma of the second gas, for example, a second plasma gas, is generated by the microwaves of the microwave generator MWP and the magnetic field of the magnetic field generator PSM. As the second gas includes hydrogen, the second plasma gas PZG2 may contain hydrogen ions and hydrogen radicals. The reaction product RGM produced on the target substrate SB is etched using the hydrogen ions and the hydrogen radicals.

In the second etching step S400, following reactions may occur in a stepwise manner or independently:

3CuCl₂(s) + 3H(g) = Cu₃Cl₃(g) + 3HCl(g)

CuCl₂(s) + 3H(g) = CuH(g) + 2HCl(g)

CuCl(s) + 2H(g) = CuH(g) + HCl(g)

3CuCl₂(s) + 3/2H₂(g) = Cu₃Cl₃(g) + 3HCl(g)

where (s) refers to a solid state, and (g) refers to a gaseous state.

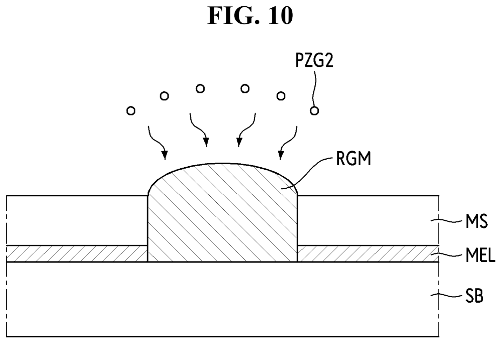

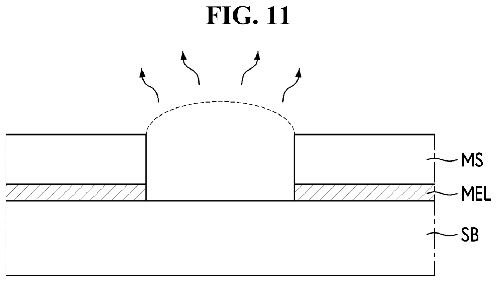

As shown in FIGS. 10 and 11, the hydrogen ions and the hydrogen radicals of the second plasma gas PZG2 generated in the second etching step 420 may react with the reaction product RGM to remove the reaction product RGM. For example, the hydrogen ions and the hydrogen radicals may react with the reaction product RGM to generate gaseous HCl, CuH, and Cu₃Cl₃. HCl, CuH, and Cu₃Cl₃ may be vaporized into a gaseous state even at a low temperature of about 150 degrees C or lower, and may be exhausted to the outside out of the chamber CB.

In one example, the temperature in the chamber CB may be increased by heat generated in the etching process and plasma energy itself. In this case, a portion of the reaction product CuCl or CuCl₂ may be vaporized and re-deposited on the chamber CB. In order to prevent the re-deposition of the reaction product, cooling the temperature of the target substrate SB may be one alternative.

In an embodiment, the target substrate SB may be cooled to remove the above-described reaction product at a low temperature of about 150 degrees C or lower.

As shown in FIG. 7, the cooling unit COL provided in the etching apparatus 200 may cool the target substrate SB through the susceptor SU. The cooling unit COL may cool the temperature of the susceptor SU to 10 degrees C or lower, for example, a temperature below 0 degrees C or -20 degrees C. The temperature of the surface of the target substrate SB may be 80 degrees C or lower.

In an embodiment, while the copper plasma etching method is performed, the temperature of the surface of the target substrate SB may be maintained at 80 degrees C or lower. Accordingly, the present method may prevent the solid state CuCl and CuCl₂ from being vaporized and re-deposited on the surface of the target substrate SB or the inner wall of the chamber CB. In addition, Cu₃Cl₃ has a boiling point of about 139 degrees C at 1mTorr. Thus, it is easy to remove Cu₃Cl₃ even at low temperatures. Accordingly, heat or additional energy for removing Cu₃Cl₃ is unnecessary, thereby improving productivity.

In an embodiment, since Cu₃Cl₃ has a boiling point of about 139 degrees C at 1mTorr, it is easy to remove Cu₃Cl₃ even at a low temperature, and thus the copper plasma etching method may be performed at a low temperature. When performing the copper plasma etching method at a conventional high temperature, a plasma source emitting high density and high electron energy was required to remove the reaction product. In this case, when a photoresist pattern is used as an etching mask for the copper layer (or the metal layer), the photoresist pattern is damaged by the plasma source, and thus it is difficult to use the photoresist pattern as the etching mask. However, in the present embodiment, since the copper plasma etching method may be performed at a low temperature, there is an advantage in that the photoresist pattern may be used as the etching mask.

In an embodiment, the first etching step S200 and the second etching step S400 constitute one cycle, and the cycle may be performed multiple times. For example, the first etching step and the second etching step may be alternately and repeatedly performed. In an embodiment, the first etching step may be performed by supplying the first etching gas, the first etching gas may be discharged, and the second etching step may be performed by supplying the second etching gas. Next, the second etching gas may be discharged, the first etching gas may be supplied again to perform the first etching step, the first etching gas may be discharged, and the second etching gas may be supplied to perform the second etching step.

When the cycle composed of the first etching step and the second etching step is performed a plurality of times, the reliability of the etching process may be improved by preventing the copper metal layer from being unetched.

Hereinafter, a copper plasma etching method according to another embodiment will be described with reference to further drawings.

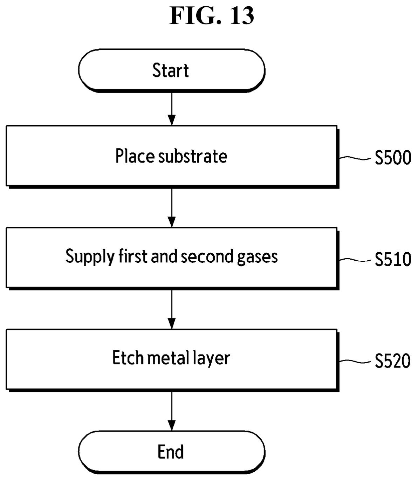

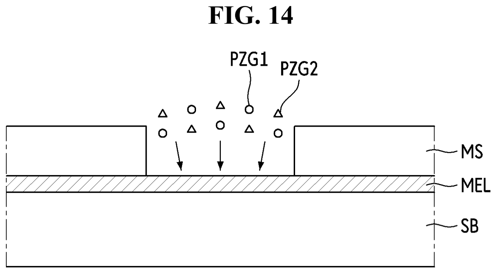

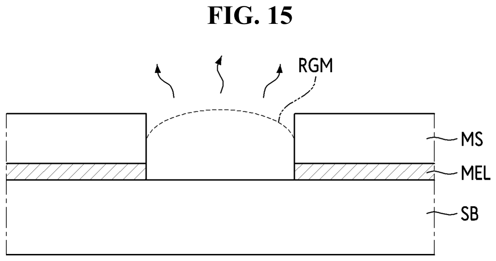

FIG. 13 is a flowchart of a copper plasma etching method according to another embodiment. FIGS. 14 and 15 are diagrams illustrating structures corresponding to steps of a copper plasma etching method according to an embodiment.

Referring to FIG. 13, the copper plasma etching method according to an embodiment may include placing the target substrate in S500, supplying the first gas and the second gas in S510, and plasma-etching the metal layer in S520. This embodiment is different from the embodiment of FIGS. 7 to 12 in that the metal layer is plasma-etched by simultaneously supplying the first gas and the second gas. In the following description, a redundant description of the same configuration as that in the above-described embodiment will be omitted, and differences therebetween will be described.

Referring to FIG. 14 in conjunction with FIG. 13, the step S500 of placing the target substrate is performed. The target substrate SB may be placed on the susceptor SU in the chamber CB. The target substrate SB may have the metal layer MEL deposited thereon and including copper, and an etching mask MS may be formed on the metal layer MEL. The etching mask MS may be a photoresist pattern or a hard mask pattern.

Subsequently, the step S510 of supplying the first gas and the second gas is performed.

In an embodiment, a vacuum state and a pressure of 10⁻⁴ to 10⁻² Torr are formed in the chamber CB of the etching apparatus 200. Subsequently, microwaves are provided in the chamber CB, and a magnetic field is formed in the chamber CB. At the same time, a high frequency is applied from the high frequency power supply RFP to the susceptor SU.

Thereafter, the first gas and the second gas are supplied into the chamber CB. The first gas and the second gas are used for plasma-etching the metal layer MEL, and may be supplied into the chamber CB through the gas supply GSP. The first gas may include chlorine, and for example, may include any one or more selected from the group consisting of Cl₂, CCl₄, BCl₃, SiCl₂, HCl, PCl₃, CHCl₂F, CHClF₂, CCl₂F₂, and ICl. The second gas may include hydrogen, and for example, the second gas may include H₂.

Next, the metal layer MEL is etched. As the first gas and the second gas are supplied into the chamber CB, the first plasma gas and the second plasma gas are generated by the microwaves of the microwave generator MWP and the magnetic field of the magnetic field generator PSM. For example, as the first gas includes chlorine, the first plasma gas PZG1 may include chlorine ions and chlorine radicals, and the second plasma gas PZG2 may include hydrogen ions and hydrogen radicals. The metal layer MEL of the target substrate SB, which is not covered with the etching mask MS, is etched using the chlorine ions, hydrogen ions, chlorine radicals, and hydrogen radicals.

In an embodiment, following reactions may occur in a stepwise manner or independently:

Cu(s) + 1/2Cl₂(g) = CuCl(s)

CuCl(s) + 1/2Cl₂(g) = CuCl₂(s)

Cu(s) + Cl₂(g) = CuCl₂(g)

3Cu(s) + 3/2Cl₂(g) = Cu₃Cl₃(g)

3CuCl₂(s) + 3H(g) = Cu₃Cl₃(g) + 3HCl(g)

CuCl₂(s) + 3H(g) = CuH(g) + 2HCl(g)

CuCl(s) + 2H(g) = CuH(g) + HCl(g)

3CuCl₂(s) + 3/2H₂(g) = Cu₃Cl₃(g) + 3HCl(g)

where (s) refers to a solid state, and (g) refers to a gaseous state.

In the embodiments of FIGS. 7 to 12 described above in which the first etching step and the second etching step are performed separately, the above-described reactions sequentially occur. However, in the present embodiment, the above-described reactions may occur substantially simultaneously as the first and second etching gases are substantially simultaneously supplied.

As shown in FIGS. 14 and 15, the chlorine ions and the chlorine radicals of the first plasma gas PZG1 react with the metal layer MEL to produce the reaction product RGM, and the reaction product RGM is etched and removed by the hydrogen ions and the hydrogen radicals of the second plasma gas PZG2. For example, the generation of the reaction product RGM by the first plasma gas PZG1 and the removal thereof using the second plasma gas PZG2 may occur substantially simultaneously. Since the reactions in which the reaction product RGM is produced by the first plasma gas PZG1 and the reactions in which the reaction product RGM is removed by the second plasma gas PZG2 are the same as those of the above-described embodiment of FIGS. 7 to 12, redundant descriptions will be omitted.

In an embodiment, the copper metal layer may be plasma-etched by simultaneously supplying the first gas and the second gas for copper plasma etching, thereby shortening the etching time of the copper metal layer and improving productivity.

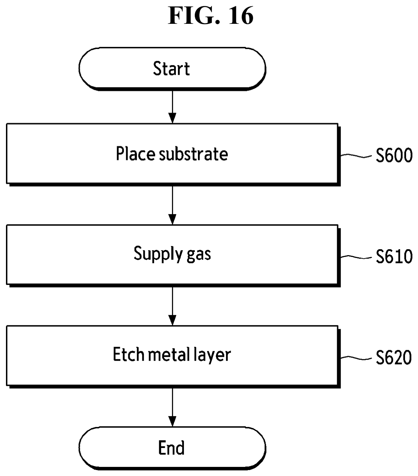

FIG. 16 is a flowchart of a copper plasma etching method according to still another embodiment.

Referring to FIG. 16, the copper plasma etching method according to an embodiment may include placing the target substrate in S600, supplying a gas in S610, and plasma-etching the metal layer in S620. This embodiment is different from the embodiment of FIGS. 13 to 15 in that a single gas is supplied to plasma-etch the metal layer. In the following description, a redundant description of the same configuration as that in the above-described embodiment will be omitted, and differences therebetween will be described.

Referring to FIG. 16, the step S600 of placing the target substrate is performed, and the step S610 of supplying the gas is performed. The gas is used for plasma-etching the metal layer MEL, and may be supplied into the chamber CB through the gas supply GSP. The gas may be the first gas which may include chlorine, and may include, for example, HCl.

Next, the metal layer MEL is etched in S620. The plasma gases are generated by the microwaves and the magnetic field in the chamber CB. For example, the first plasma gas may contain the chlorine ions and chlorine radicals as the gas includes chlorine, and may further contain the hydrogen ions and hydrogen radicals as the gas includes hydrogen. The metal layer MEL of the target substrate SB which is not covered with the etching mask MS is etched by the chlorine ions, hydrogen ions, chlorine radicals, and hydrogen radicals.

In an embodiment, HCl may be supplied as the gas for etching. In this case, the first gas for etching may not include H₂. In an embodiment, the same reactions as in the embodiment of FIGS. 13 to 15 as described above may occur substantially simultaneously. For example, the chlorine ions and the chlorine radicals of the first plasma gas may react with the metal layer to produce the reaction product, and the reaction product may be etched and removed by the hydrogen ions and the hydrogen radicals of the second plasma gas at the same time.

As described above, plasma-etching the copper metal layer by supplying the single gas of HCl for copper plasma etching may allow the etching process to be simplified and allow an etching time of the copper metal layer to be shortened, thereby improving productivity.

Hereinafter, Experimental Examples of a copper plasma etching method according to the above-described embodiments are disclosed. However, the present disclosure is not limited by the following Experimental Examples.

### <Experimental Example 1>

A copper plasma etching method for forming copper line was performed using HCl and H₂ gas. In an embodiment, a copper metal layer was deposited on a glass substrate, a silicon oxide (SiOₓ) layer as a hard mask was deposited on the copper metal layer, and a photoresist pattern was formed on the silicon oxide layer. In this regard, the plasma etching was performed using electron cyclotron resonance, and the etching process was performed at a pressure of 10⁻² Torr for about 120 seconds, and the temperature of the substrate surface was maintained at 80 degrees C or lower.

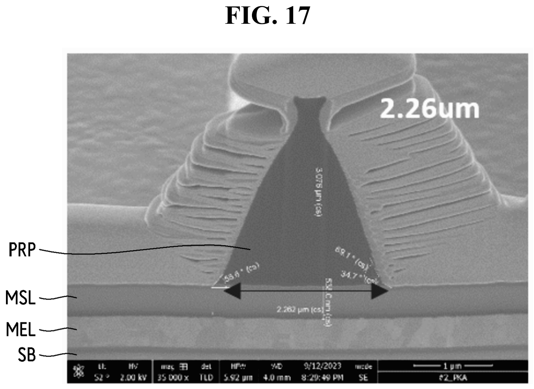

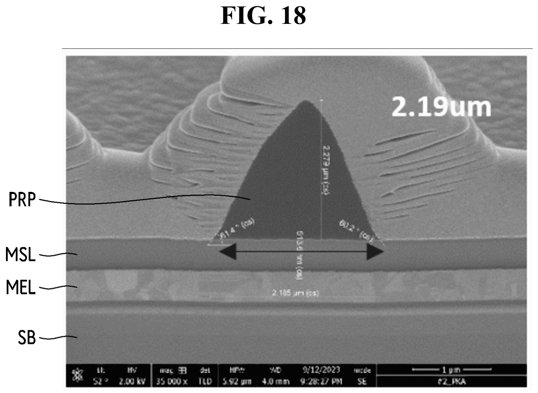

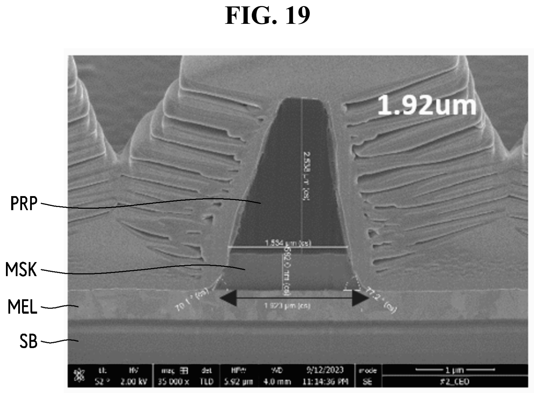

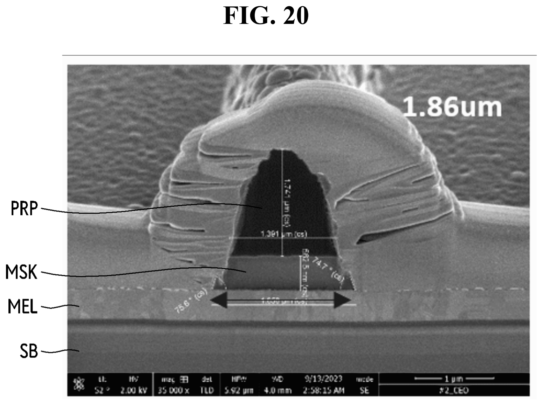

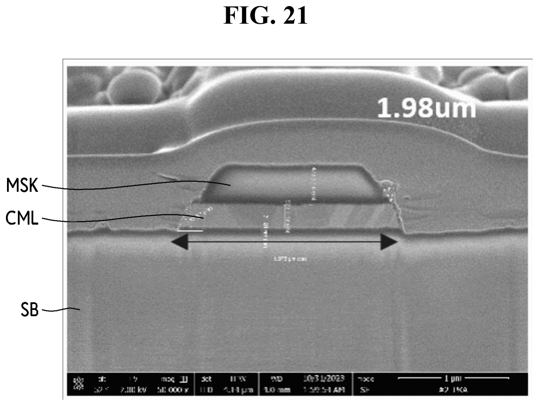

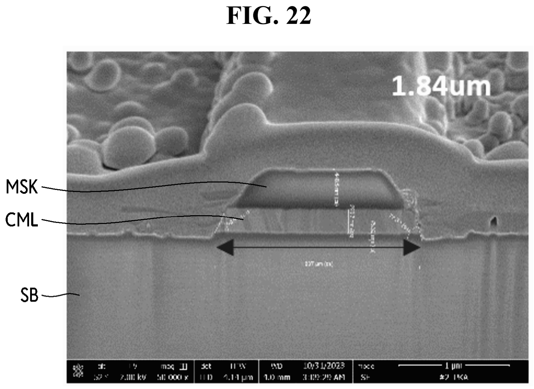

FIG. 17 is an inspection (ADI) image after development of an edge portion of the copper line according to Experimental Example 1; FIG. 18 is an inspection (ADI) image after development of a center portion of the copper line according to Experimental Example 1; FIG. 19 is an inspection (AEI) image after etching the edge portion of the copper line according to Experimental Example 1; FIG. 20 is an inspection (AEI) image after etching of the center portion of the copper line according to Experimental Example 1; FIG. 21 is an inspection (ACI) image after cleaning of the edge portion of the copper line according to Experimental Example 1; and FIG. 22 is an inspection (ACI) image after cleaning of the center portion of the copper line according to Experimental Example 1.

Referring to FIGS. 17 and 18, a copper metal layer MEL, a hard mask layer MSL, and a photoresist pattern PRP were formed on a glass substrate SB. A line width of the photoresist pattern PRP at an edge portion of a copper line to be formed was about 2.26 *µ*m, and a line width of the photoresist pattern PRP at a center portion thereof was about 2.19 *µ*m.

Referring to FIGS. 19 and 20, a hard mask MSK was formed by etching the hard mask layer using the photoresist pattern PRP as a mask. A line width of the hard mask MSK in the edge portion of the copper line to be formed was about 1.92 *µ*m, and a line width of the hard mask MSK in the center portion thereof was about 1.86 *µ*m.

Referring to FIGS. 21 and 22, the metal layer was etched using the hard mask MSK as a mask to form a copper line CML. A line width of the edge portion of the copper line CML was about 1.98 *µ*m, and a line width of the center portion thereof was about 1.84 *µ*m.

In Experimental Example 1, a skew value (a difference between a line width of the inspection after etching of the copper line and a line width of the inspection after cleaning thereof) of the copper line was about -0.06 *µ*m at the edge portion and about 0.02 *µ*m at the center portion. For example, the skew value of the copper line was within a range of - 0.06 *µ*m to 0.02 *µ*m, and it was identified that the skew value was approximate to 0.

When the copper plasma etching method according to the above-described embodiment is used, the ratio (L/S) of the line width of the copper line to the spacing between the copper lines may be in a range of 1.1/1.5 to 1.1/1.1. For example, the ratio (L/S) of the line width of the copper line to the spacing between the copper lines may be realized as 1.1/1.5, 1.1/1.1, or 0.8/1.0. For example, the line width of the copper line may be in a range of 0.8 to 1.1, and the spacing between the copper lines may be in a range of 1.0 to 1.5. In addition, when the ratio of the line width of the copper line to the spacing between the copper lines is 1.1/1.5, a resolution of about 1700ppi may be realized. When the ratio of the line width of the copper line to the spacing between the copper lines is 1.1/1.1 or 0.8/1.0, a resolution of about 1500ppi may be realized. Therefore, using the above-described copper plasma etching method, a high resolution of about 1500ppi to 1700ppi may be realized. Accordingly, the display device according to an embodiment may realize a resolution of about 300ppi to 1700ppi.

### <Experimental Example 2>

Under the same process condition as in Experimental Example 1, the copper metal layer was etched only using the photoresist pattern instead of the hard mask. In an embodiment, a copper metal layer was deposited on a glass substrate, and a photoresist pattern was formed on the copper metal layer.

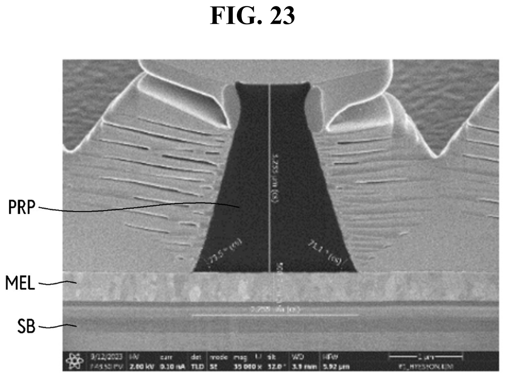

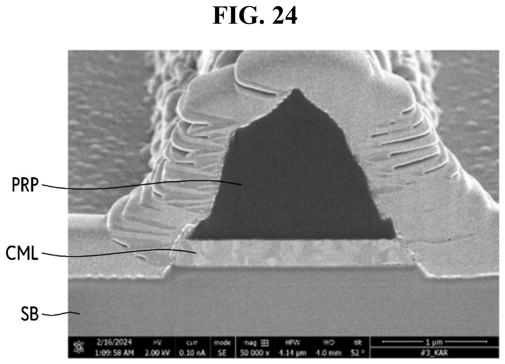

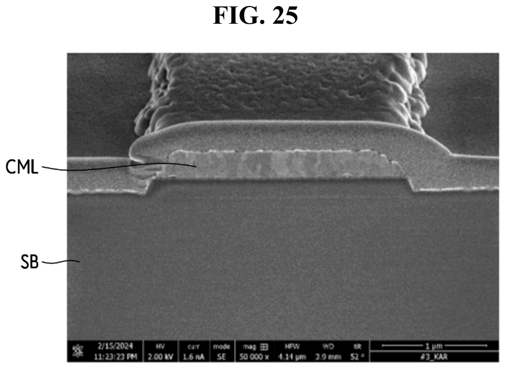

FIG. 23 is an inspection (ADI) image after development of the copper line according to Experimental Example 2. FIG. 24 is an inspection (AEI) image after etching of the copper line according to Experimental Example 2. FIG. 25 is an inspection (ACI) image after cleaning of the copper line according to Experimental Example 2.

Referring to FIG. 23, the copper metal layer MEL and the photoresist pattern PRP were formed on the glass substrate SB. In this regard, a thickness of the photoresist pattern PRP was found to be about 3.0 *µ*m.

Referring to FIG. 24, copper plasma etching was performed using the photoresist pattern PRP as a mask to form a copper line CML. In this regard, a thickness of a remaining portion of the photoresist pattern PRP was found to be about 2.3 *µ*m.

Referring to FIG. 25, the photoresist pattern PRP was removed. It was identified on the image that the photoresist pattern did not remain and was entirely removed.

Thus, it was identified that the copper plasma etching may be performed by omitting the hard mask and using only the photoresist pattern.

### <Experimental Example 3>

A silicon oxide (SiOx) was deposited on a glass substrate to form an insulating layer INS, and a copper metal layer was deposited thereon and then etched to form a copper line CML. In this case, the etching method was performed in two different manners: the plasma etching of the above-described embodiment and wet etching, the mask is embodied as two mask types: the photoresist pattern and the hard mask, and the strip process of the mask is present or absent. XPS analysis (X-ray Photoelectron Spectroscopy) was performed on the surface of the insulating layer INS on which the copper line CML was not disposed under each condition.

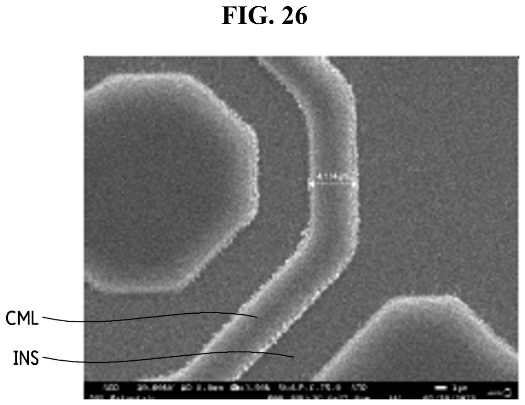

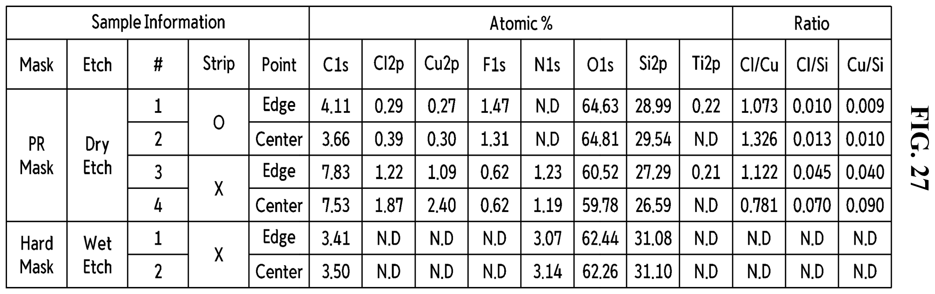

FIG. 26 is an image showing an insulating layer and a copper line manufactured according to Experimental Example 3. FIG. 27 is a table showing XPS analysis results of an insulating layer according to Experimental Example 3.

Referring to FIG. 26, it was identified that the copper line CML was formed on the insulating layer INS according to Experimental Example 3.

Referring to FIG. 27, chlorine (Cl) and copper (Cu) were not detected on the surface of the insulating layer after the copper line was wet-etched using the hard mask.

On the other hand, in the copper plasma etching process using the photoresist pattern, chlorine and copper were detected on the surface of the insulating layer regardless of absence or presence of the strip process. In particular, a larger amount of each of chlorine and copper was detected in the case where the strip process was not performed than in the case where the strip process was performed. In addition, when the strip process was performed, the content of chlorine was detected to be greater than that of copper.

Based on this result, it was identified that copper and chlorine were detected on the surface of the insulating layer after the copper plasma etching process. In particular, the atomic ratio of chlorine on the surface of the insulating layer was in a range of about 0.29at% to about 1.87at%, and the atomic ratio of copper thereon was in a range of about 0.27at% to about 2.40at%.

In an embodiment, the above-described copper plasma etching process may be variously monitored. For example, in the copper plasma etching process, a termination timing of the etching process may be detected using optical emission spectroscopy (OES), resin gas analyzer (RGA), quadratic mass spectrometer (QMS), etc., and the etching process may be monitored based on an analyzing result of an amount of an etching byproduct or a vaporized material.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

## Claims

1. A display device (10) comprising:
a substrate;
an insulating layer on the substrate;
at least one transistor on the insulating layer;
at least one signal line on the insulating layer and connected to the at least one transistor; and
a light-emitting element connected to the at least one transistor,
wherein the signal line comprises copper, and
wherein a surface of the insulating layer comprises chlorine.

2. The display device of claim 1, wherein the surface of the insulating layer further comprises copper.

3. The display device of claim 2, wherein a content of the chlorine is greater than a content of the copper.

4. The display device of any one of the preceding claims, wherein a ratio of a line width of each of the at least one signal line to a spacing between signal lines is in a range of 0.8/1.5 to 1.0/1.0.

5. The display device of any one of the preceding claims, wherein the at least one signal line is at least one of a scan line, a data line, an initialization voltage line, a sensing line, a first voltage line, and a second voltage line electrically connected to the at least one transistor.

6. A copper plasma etching method comprising:
placing a substrate into a chamber of a plasma etching apparatus (200), wherein the substrate has a metal layer formed thereon and comprising copper;
supplying a first gas comprising chlorine into the chamber;
performing a first etching step of plasma-etching the metal layer;
optionally, after the first etching step, discharging the first gas;
supplying a second gas comprising hydrogen into the chamber; and
performing a second etching step of plasma-etching the metal layer.

7. The copper plasma etching method of claim 6, wherein the first gas comprising chlorine comprises at least one selected from the group consisting of Cl₂, CCl₄, BCl₃, SiCl₂, HCl, PCl₃, CHCl₂F, CHClF₂, CCl₂F₂, and ICl.

8. The copper plasma etching method of claim 6 or 7, wherein the first gas does not comprise H₂.

9. The copper plasma etching method of claim 7, wherein the first gas comprises HCl.

10. The copper plasma etching method of any one of claims 6 to 9, wherein a photoresist pattern as an etch mask is formed on the metal layer of the substrate.

11. The copper plasma etching method of any one of claims 6 to 10, wherein the first etching step and the second etching step constitute one cycle, and the cycle is performed a plurality of times.

12. The copper plasma etching method of any one of claims 6 to 11, wherein a temperature of a surface of the substrate is 80 degrees C or lower.

13. The copper plasma etching method of any one of claims 6 to 12, wherein in the plasma etching, following reactions occur:
Cu(s) + 1/2Cl₂(g) = CuCl(s)
CuCl(s) + 1/2Cl₂(g) = CuCl₂(s)
Cu(s) + Cl₂(g) = CuCl₂(g)
3Cu(s) + 3/2Cl₂(g) = Cu₃Cl₃(g)
3CuCl₂(s) + 3H(g) = Cu₃Cl₃(g) + 3HCl(g)
CuCl₂(s) + 3H(g) = CuH(g) + 2HCl(g)
CuCl(s) + 2H(g) = CuH(g) + HCl(g)
3CuCl₂(s) + 3/2H₂(g) = Cu₃Cl₃(g) + 3HCl(g)
where (s) refers to a solid state, and (g) refers to a gaseous state.

14. An electronic device (1) comprising:
a display device (10) for displaying an image as defined in any one of claim 1 to 5;
a memory (13) storing therein data information necessary for operation of the display device;
a processor (12) configured to execute an application stored in the memory; and
a power module (14) configured to supply power to the display device, the memory, and the processor.

15. The electronic device of claim 14, wherein the display device (10) has a resolution of 300ppi to 1700ppi.
